# EUROPÄISCHE PATENTSCHRIFT

(11) **EP 3 574 513 B1**
(45) Veröffentlichungstag und Bekanntmachung des Hinweises auf die Patenterteilung: **17.04.2024**
(21) Anmeldenummer: 18701736.3
(22) Anmeldetag: 24.01.2018
(51) Int. Cl.: H01F 38/14, H01F 27/02, H01F 27/22

(54) **EMPFANGSVORRICHTUNG UND VERFAHREN ZUR HERSTELLUNG**
RECEIVING DEVICE, AND METHOD FOR PRODUCING SAME
DISPOSITIF RÉCEPTEUR ET SON PROCÉDÉ DE FABRICATION

(30) Priorität: 26.01.2017 DE 102017101582
(43) Veröffentlichungstag der Anmeldung: 04.12.2019
(73) Patentinhaber: ENRX IPT GmbH, 79588 Efringen-Kirchen (DE); AUDI AG, 85045 Ingolstadt (DE)
(72) Erfinder: WECHSLER, Simon, 68165 Mannheim (DE); GUNT, Roman, 69120 Heidelberg (DE)
(74) Vertreter: Ramrath, Lukas
(86) Internationale Anmeldenummer: PCT/EP2018/051686
(87) Internationale Veröffentlichungsnummer: WO 2018/138128

(56) Entgegenhaltungen:
- EP-A1- 2 618 344
- EP-A1- 2 960 910
- EP-A2- 2 493 016
- DE-A1- 10 312 284
- KR-B1- 101 504 744
- US-A1- 2012 235 421
- US-A1- 2016 118 315

## Beschreibung

Die Erfindung betrifft eine Empfangsvorrichtung für ein System zur induktiven Leistungsübertragung sowie ein Verfahren zur Herstellung einer solchen Empfangsvorrichtung.

Insbesondere betrifft die Erfindung eine Empfangsvorrichtung zum Empfang eines elektromagnetischen Feldes und zum induktionsbasierten Bereitstellen elektrischer Energie, insbesondere für die Nutzung durch ein Fahrzeug, weiter insbesondere durch ein Automobil.

Eine Anwendung der Erfindung kann insbesondere im Bereich der drahtlosen Energieübertragung zu Fahrzeugen, wie z.B. Automobilen, Bussen, Vans, Lastkraftwagen, Gabelstaplern und Schienenfahrzeugen, liegen. Die Empfangsvorrichtung kann hierfür insbesondere zur Bereitstellung von elektrischer Leistung im Bereich mehrerer Kilowatt, z.B. 20 kW, sein.

Während einer Fahrt auf einer Fahrbahn kann ein Fahrzeug Energie zum Antrieb und für den Betrieb von Zusatzeinrichtungen, die nicht zum Antrieb des Fahrzeuges dienen, benötigen. Zusatzeinrichtungen können beispielsweise ein Lichtsystem, ein Heizsystem und/oder eine Klimaanlage, ein Lüftungssystem und ein Informationssystem umfassen. Weiter ist bekannt, dass nicht nur schienengebundene Fahrzeuge, wie z.B. Straßenbahnen, sondern auch Straßenfahrzeuge mit elektrischer Energie betrieben werden können.

Fahrzeuge, insbesondere Elektrofahrzeuge, können in verschiedenen Weisen mit elektrischer Energie versorgt werden. Eine Möglichkeit ist, eine fahrzeugseitig installierte Batterie zu laden, wenn das Fahrzeug steht. Hierfür kann eine Kabelverbindung zum Fahrzeug hergestellt werden. Eine andere Möglichkeit ist es, Energie drahtlos zum Fahrzeug zu übertragen, wobei ein elektromagnetisches Feld genutzt wird, welches in mindestens einer Induktivität im Fahrzeug eine elektrische Spannung induziert. Der Begriff "Empfangsvorrichtung" oder "Pick-up" kann hierbei eine Vorrichtung bezeichnen, die eine solche Induktivität umfasst.

Die induktionsbasierte Übertragung von elektrischer Energie zum Fahrzeug bildet den Hintergrund dieser Erfindung. Eine fahrbahnseitige Leiteranordnung, die auch als Primärwindungsstruktur bezeichnet werden kann, erzeugt ein elektromagnetisches Feld zur Leistungsübertragung. Dieses Feld wird von einer fahrzeugseitig angeordneten Leiteranordnung, die auch als Sekundärwindungsstruktur oder Sekundärspule bezeichnet werden kann, im Fahrzeug empfangen, wobei das elektromagnetische Feld eine elektrische Spannung durch Induktion erzeugt. Die derart übertragene Energie kann zum Antrieb des Fahrzeugs und/oder für andere Anwendungen, wie z.B. die Versorgung von Zusatzeinrichtungen des Fahrzeugs, dienen. Das Fahrzeug kann z.B. ein Fahrzeug mit einem elektrisch betreibbaren Antriebsmotor sein. Allerdings kann das Fahrzeug auch ein sogenanntes hybrides Antriebssystem umfassen, z.B. ein System, welches mit elektrischer Energie oder anderer Energie, die z.B. durch die Nutzung von Kraftstoff, wie z.B. Gas, Diesel oder Benzin oder Wasserstoff, betrieben werden kann.

Es besteht ein Bedürfnis zur Integration einer Empfangsvorrichtung mit einer Sekundärwindungsstruktur in existierende Fahrzeuge, insbesondere Automobile. Ein Gewicht der Empfangsvorrichtung sollte gering sein, um ein Gesamtgewicht des Fahrzeugs so wenig wie möglich zu beeinträchtigen. Weiterhin sollten die Konstruktion der Empfangsvorrichtung stabil und die Montage der Empfangsvorrichtung einfach durchführbar sein. Weiter sollten existierende Bauräume, insbesondere im Bereich einer Unterseite eines Fahrzeugs, genutzt werden.

Typischerweise wird das magnetische Feld (als Teil eines elektromagnetischen Wechselfeldes) durch eine Vorrichtung erzeugt, die unter der Fahrzeugunterseite angeordnet ist. Darum wird eine Empfangsvorrichtung typischerweise an der Unterseite des Fahrzeugs montiert, um das magnetische Feld von unten zu empfangen. Allerdings ist es auch möglich, die Empfangsvorrichtung in weitere Richtungen, wie z.B. eine horizontale Richtung, zu orientieren, falls die Vorrichtung zum Erzeugen des elektromagnetischen Feldes in der entsprechenden Richtung angeordnet ist, z.B. an einer Wand. Generell weist die Empfangsvorrichtung eine Empfangsseite auf, wobei während des Betriebes das magnetische Feld von der Empfangsseite her in die Empfangsvorrichtung eintritt.

WO 2014/166963 A1 offenbart eine Empfangsvorrichtung zum Empfang eines magnetischen Feldes und zum Bereitstellen elektrischer Energie durch magnetische Induktion, wobei die Empfangsvorrichtung zumindest eine Spule einer elektrischen Leitung umfasst. Weiterhin induziert das magnetische Feld eine elektrische Spannung in der Spule während eines Betriebes. Weiterhin umfasst die Spule eine Induktivität, wobei die Empfangsvorrichtung und die Spule derart ausgebildet sind, dass das magnetische Feld von einer Empfangsseite her empfangen werden kann. Weiterhin umfasst die Empfangsvorrichtung ein Gehäuse, welches die zumindest eine Spule und weitere Komponenten der Empfangsvorrichtung umfasst.

WO 2015/150297 A2 offenbart eine Empfangsvorrichtung, insbesondere eine Empfangsvorrichtung für ein System zur induktiven Leistungsübertragung zu einem Fahrzeug, wobei die Empfangsvorrichtung ein Gehäuse umfasst. Weiterhin ist zumindest ein Medium in dem Gehäuse angeordnet, wobei das Medium einen thermischen Ausdehnungskoeffizienten aufweist, der kleiner als der thermische Ausdehnungskoeffizient von Luft ist.

Die EP 2 960 910 A1 offenbart eine Leistungsübertragungseinrichtung zum nichtkontaktbasierten Übertragen von Leistung.

Die EP 2 618 344 A1 offenbart einen Übertrager, der für das drahtlose Laden von Elektrofahrzeugen genutzt wird.

Die DE 103 12 284 A1 offenbart einen Übertragerkopf und ein System zur berührungslosen Energieübertragung.

Die US 2012/235421 A1 offenbart das Kühlen von wärmeerzeugenden Komponenten innerhalb einer Windturbinengondel.

Die US 2016/118315 A1 offenbart Techniken und Konfigurationen zur Wärmeabfuhr von Multichip-Packages, wie beispielsweise eine Kühlkörperkopplung durch flexible Wärmerohre für Mehroberflächenkomponenten.

Die KR 101 504 744 B1 offenbart eine Kühlkörperanordnung für eine elektronische Vorrichtung zum Kühlen von Heizquellen, die mit mehreren Heizquellen in Kontakt stehen, die auf der Oberfläche einer Platine zum Erhitzen angeordnet sind.

Zusätzlich zu einer Empfangswindungsstruktur (Sekundärwindungsstruktur) kann die Empfangsvorrichtung weitere elektrische und elektronische Komponenten umfassen. Beispielsweise kann die Empfangsvorrichtung einen Gleichrichter umfassen, wobei der Gleichrichter leistungselektronische Elemente umfassen kann. Weiter kann die Empfangsvorrichtung Regelungs- und Messelemente umfassen. Diese Komponenten können thermische Energie erzeugen.

Während eines Betriebes des Fahrzeugs mit einer solchen Empfangsvorrichtung können große Temperaturänderungen der Temperatur im Gehäuse auftreten. Um einen zuverlässigen Betrieb der Empfangsvorrichtung, insbesondere der elektrischen und elektronischen Komponenten, zu ermöglichen, ist es wünschenswert, eine zuverlässige Kühlung zu ermöglichen.

Es stellt sich das technische Problem, eine Empfangsvorrichtung sowie ein Verfahren zur Herstellung einer solchen Empfangsvorrichtung zu schaffen, die eine zuverlässige Kühlung der Empfangsvorrichtung, insbesondere von elektrischen und/oder elektronischen Elementen der Empfangsvorrichtung, ermöglichen. Die zuverlässige Kühlung sollte auch dann gewährleistet werden, wenn Anforderungen hinsichtlich der Montage der Empfangsvorrichtung an einem Fahrzeug zu erfüllen sind.

Die Lösung des technischen Problems ergibt sich durch die Gegenstände mit den Merkmalen der Ansprüche 1 und 10. Weitere vorteilhafte Ausgestaltungen der Erfindung ergeben sich aus den Unteransprüchen.

Vorgeschlagen wird eine Empfangsvorrichtung für ein System zur induktiven Leistungsübertragung.

Das System kann insbesondere zur induktiven Leistungsübertragung zu einem Fahrzeug, insbesondere einem Automobil, dienen. Die Empfangsvorrichtung umfasst ein Gehäuse, wobei das Gehäuse als Gehäuseteile einen Deckelteil und einen Bodenteil umfasst.

Das Gehäuse kann an einem Fahrzeug montiert werden. Insbesondere kann das Gehäuse an einem Fahrzeugrahmen, weiter insbesondere an einem Vorderachsträger, des Fahrzeugs montiert werden. Weiter kann das Gehäuse an oder im Bereich einer Unterseite des Fahrzeugs am Fahrzeug montiert werden. Das Gehäuse kann mindestens ein Befestigungsmittel aufweisen, um das Gehäuse am Fahrzeug zu montieren. Es ist beispielsweise möglich, dass das Deckelteil und/oder das Bodenteil zumindest eine, vorzugsweise mehrere, Öffnung/en zur Aufnahme einer Schraube aufweisen. Dies erlaubt das Verschrauben des Gehäuses mit dem Fahrzeug.

In einem montierten Zustand, in dem die Empfangsvorrichtung an dem Fahrzeug montiert ist, ist das Deckelteil über dem Bodenteil angeordnet. Nachfolgend kann auf das folgende Koordinatensystem der Empfangsvorrichtung Bezug genommen werden.

Eine Vertikalachse der Empfangsvorrichtung kann senkrecht zu einer Oberseite des Deckelteils und einer Unterseite des Bodenteils orientiert sein. Eine Längsachse der Empfangsvorrichtung kann parallel zu einer Längsrichtung des Gehäuses orientiert sein. Eine Querachse (auch Lateralachse) der Empfangsvorrichtung kann parallel zu einer Querachse des Gehäuses orientiert sein. Hierbei kann eine Breite des Gehäuses entlang der Lateralachse kleiner als eine Länge entlang der Längsachse sein. Im montierten Zustand kann die Vertikalachse parallel zu einer Vertikalachse oder einer Gierachse des Fahrzeugs orientiert sein. Weiter kann die Querachse der Empfangsvorrichtung parallel zu einer Querachse oder Nickachse des Fahrzeuges orientiert sein. Weiter kann die Längsachse der Empfangsvorrichtung parallel zu einer Längsachse oder Rollachse des Fahrzeugs orientiert sein. Die Achsen können weiter senkrecht zueinander orientiert sein.

Weiter weist das Gehäuse ein Innenvolumen zur Aufnahme mindestens einer Windungsstruktur, nämlich der Sekundärwindungsstruktur, auf. In einem geschlossenen Zustand, in dem das Deckelteil und das Bodenteil aneinander befestigt sind, kann das Innenvolumen von dem Deckel- und Bodenteil umfasst werden. Das Innenvolumen wird somit von dem Deckel- und Bodenteil begrenzt.

Das Innenvolumen kann neben der Aufnahme der Windungsstruktur auch zur Aufnahme weiterer Komponenten der Empfangsvorrichtung, insbesondere elektrischer und elektronischer Komponenten, dienen. Diese können beispielsweise auf einer, zwei oder mehreren Leiterplatten angeordnet sein, wobei die Leiterplatten ebenfalls im Innenvolumen angeordnet werden können. Weiter ist in dem Innenvolumen ein magnetisch leitfähiges Element, insbesondere ein Ferritelement, angeordnet. Die Empfangsvorrichtung kann diese weiteren Komponenten, Leiterplatten und/oder das magnetisch leitfähige Element umfassen.

Die Windungsstruktur kann eine erste und mindestens eine weitere Teilwindung umfassen. Die erste und die zumindest eine weitere Teilwindung sind elektrisch verbunden.

Die Windungsstruktur empfängt das elektromagnetische Feld und stellt eine induzierte Ausgangsspannung bereit. In diesem Fall empfängt die erste Teilwindung einen ersten Anteil des elektromagnetischen Felds und die zweite Teilwindung einen weiteren Anteil des elektromagnetischen Felds, wenn die Windungsstruktur dem elektromagnetischen Feld ausgesetzt ist. Jede Teilwindung kann einen Pol des elektromagnetischen Felds, das durch den induzierten Strom erzeugt wird, bereitstellen.

Eine Teilwindung kann einen oder mehrere Abschnitt(e) einer Phasenleitung der Windungsstruktur umfassen. Die Windungsstruktur kann eine oder mehrere Phasenleitung(en) zum Leiten eines elektrischen Stroms umfassen. Eine Teilwindung kann eine vorbestimmte Fläche umfassen. Eine Teilwindung kann eine Spule, beispielsweise mit einer vorbestimmten Windungszahl, aufweisen oder ausbilden.

Die zumindest eine Phasenleitung kann derart ausgebildet sein, dass ein Verlauf der Phasenleitung eine gerade oder eine ungerade Anzahl von Teilwindungen ausgebildet, die benachbart zueinander angeordnet sind. In diesem Fall bezeichnet eine Teilwindung eine, bevorzugt geschlossene, Leiterschleife die die vorbestimmte Fläche umfasst. Die Leiterschleife kann eine oder mehrere Windung(en) der entsprechenden Teilwindung umfassen oder ausbilden.

Benachbart zueinander kann bedeuten, dass zentralen Achsen der Teilwindungen, insbesondere Symmetrieachsen, entlang einer geraden Linie beabstandet voneinander angeordnet sind, insbesondere mit einem vorbestimmten Abstand. Die gerade Linie kann parallel zur longitudinalen Richtung der Empfangseinrichtung sein. Dies kann bedeuten, dass die Phasenleitung der Windungsstruktur sich entlang einer Erstreckungsrichtung erstrecken kann, wobei die vorbestimmte Anzahl von Teilwindungen entlang der Erstreckungsrichtung bereitgestellt wird.

Benachbarte Teilwindungen können entgegengesetzt orientiert sein. In diesem Kontext kann entgegengesetzt bedeuten, dass ein Stromfluss in der ersten Teilwindung im Uhrzeigersinn orientiert ist, wobei der Stromfluss in der benachbarten Teilwindung entgegen dem Uhrzeigersinn orientiert ist. Der Uhrzeigersinn kann mit Bezug auf parallele zentralen Achsen definiert sein, die in die gleiche Richtung orientiert sind. Wenn ein Strom in den Teilwindungen fließt, können benachbarte Teilwindungen ein magnetisches Feld mit der gleichen Stärke, jedoch entgegengesetzter Orientierung erzeugen.

Bevorzugt hat die Windungsstruktur die Form einer Acht. Dies kann bedeuten, dass ein Verlauf der mindestens einen Phasenleitung ein achtförmiger Verlauf ist. In diesem Fall kann die Phasenleitung zwei, z.B. kreis- oder rechteckförmige, Teilwindungen aufweisen, die benachbart zueinander entlang der vorhergehend erläuterten Erstreckungsrichtung angeordnet sind.

Bevorzugt umfasst die Windungsstruktur eine erste und eine zweite Teilwindung. In diesem Fall kann die Windungsstruktur auch als Doppel-D-Windungsstruktur bezeichnet werden.

Weiter weist mindestens eines der Gehäuseteile an einer Außenseite mindestens einen Kühlkörper auf. Vorzugsweise weist das Deckelteil an einer Außenseite des Deckelteils den mindestens einen oder mehrere Kühlkörper auf. Der Kühlkörper kann hierbei insbesondere derart angeordnet und/oder ausgebildet sein, dass eine Wärmeabgabe über Konvektion ermöglicht und insbesondere maximiert wird.

Der Kühlkörper kann hierbei vorzugsweise an einem außenliegenden Abschnitt der Gehäusewand, insbesondere einem außenliegenden Abschnitt des Deckelteils, angeordnet sein. Ein außenliegender Abschnitt kann hierbei einen Abschnitt bezeichnen, der mit einem Außenvolumen in Kontakt ist. Im Gegensatz dazu kann ein innenliegender Abschnitt des Gehäuses oder der Gehäusewand einen Abschnitt bezeichnen, der mit dem Innenvolumen des Gehäuses in Kontakt ist.

Der mindestens eine Kühlkörper kann von dem Gehäuseteil abstehen. Insbesondere kann der mindestens eine Kühlkörper senkrecht von dem Gehäuseteil abstehen.

Das Deckelteil ist hierbei aus einem thermisch leitfähigen Material, insbesondere aus Aluminium oder einer Aluminiumlegierung, ausgebildet. Das Deckelteil kann insbesondere in einem Druckgussverfahren hergestellt werden. Somit kann thermische Energie aus dem Innenvolumen über das mindestens eine Gehäuseteil und über den mindestens einen Kühlkörper in das Außenvolumen übertragen bzw. abgegeben werden. Hierdurch ergibt sich in vorteilhafter Weise eine zuverlässige und quantitativ ausreichende Kühlung des Innenvolumens.

Weiter umfasst die Empfangsvorrichtung mindestens ein Wärmeübertragungselement, wobei durch das mindestens eine Wärmeübertragungselement thermische Energie von einem ersten vorbestimmten räumlichen Bereich im Innenvolumen zu einem innenliegenden Abschnitt der Gehäusewand übertragbar ist. Das Wärmeübertragungselement ist hierbei von dem Deckelteil verschieden. Insbesondere kann das Wärmeübertragungselement als von dem Deckelteil verschiedenes Bauteil ausgebildet sein.

Erfindungsgemäß ist der mindestens eine Kühlkörper oder ein weiterer Kühlköper in einem diesem innenliegenden Abschnitt gegenüberliegenden außenliegenden Abschnitt der Gehäusewand angeordnet. Der innenliegende Abschnitt der Gehäusewand kann hierbei einem räumlichen Bereich des Innenvolumens angeordnet sein, der von dem vorbestimmten räumlichen Bereich verschieden ist. Weiter kann der innenliegende Abschnitt der innenliegende Abschnitt sein, an dem das magnetisch leitfähige Element anliegt oder mit dem das magnetisch leitfähige Element thermisch verbunden ist. Vorzugsweise ist jedoch der innenliegende Abschnitt, zu dem thermische Energie durch das mindestens eine Wärmeübertragungselement übertragbar ist, von dem genannten innenliegenden Abschnitt verschieden. In diesem Fall kann das Gehäuse also an einer Außenseite mindestens zwei Kühlkörper aufweisen. Der vorbestimmte räumliche Bereich kann ein Bereich sein, in den im Betrieb eine große Menge thermischer Energie übertragen wird.

Hierdurch ergibt sich in vorteilhafter Weise, dass thermische Energie in dem Innenvolumen verteilt werden kann, insbesondere zu Bereichen, in denen eine gute Wärmeübertragung zum Außenvolumen möglich ist.

Beispielsweise kann die Empfangsvorrichtung elektrische und/oder elektronische Elemente, insbesondere leistungselektronische Elemente wie z.B. elektronische Schaltelemente, insbesondere MOSFIT oder IGBT, oder Leistungsdioden umfassen, die thermische Energie erzeugen können. Um eine möglichst geringe Bauhöhe des Gehäuses zu erreichen und gleichzeitig eine zentrale Anordnung der Sekundärwindungsstruktur relativ zum Fahrzeug zu erreichen, kann es erforderlich sein, diese elektrischen oder elektronischen Elemente in Randbereichen des Gehäuses neben der Sekundärwindungsstruktur, die in einem zentralen Bereich des Gehäuses angeordnet ist, anzuordnen. Gleichzeitig ist jedoch gewünscht, das Gehäuse möglichst stabil am Fahrzeug zu montieren. Hierzu kann es vorteilhaft sein, entsprechende Befestigungsmittel, z.B. Durchgangsöffnungen und/oder Gewindeabschnitte zur Aufnahme von Schrauben, in diesen Randbereichen vorzusehen, wobei davon ausgegangen werden kann, dass eine mechanische Befestigung von Randbereichen des Gehäuses am Fahrzeug eine stabilere Befestigung ermöglicht als eine Befestigung von einem zentralen Bereich des Gehäuses. Werden jedoch Randbereiche am Fahrzeug befestigt, so steht wenig oder kein Bauraum für Kühlkörper an der Außenseite des Gehäuses, insbesondere an der Außenseite des Deckelteils, in diesen Randbereichen zur Verfügung. Um eine möglichst gute und zuverlässige Abfuhr von thermischer Energie aus dem Innenvolumen in diesen Randbereichen zu ermöglichen, muss diese thermische Energie somit zu einem Abschnitt der Gehäusewand geführt werden, deren korrespondierender außenliegende Abschnitt einen Kühlkörper aufweist.

Das Wärmeübertragungselement ermöglicht somit in vorteilhafter Weise eine gezielte Verteilung thermischer Energie, wodurch einerseits eine gute und zuverlässige Abfuhr von thermischer Energie aus dem vorbestimmten räumlichen Bereich ermöglicht wird und eine ungewünschte Erwärmung weiterer Bereiche des Innenvolumens vermieden wird. Dies wiederum erhöht eine Betriebssicherheit der Empfangsvorrichtung.

Weiter erfindungsgemäß ist der erste räumliche Bereich ein lateraler Randbereich des Gehäuses. Ein lateraler Randbereich bezeichnet hierbei einen Bereich an einer Stirnseite des Gehäuses entlang der Lateralachse der Empfangsvorrichtung. Zwischen den lateralen Randbereichen an den gegenüberliegenden Stirnseiten kann ein zentraler Bereich angeordnet sein. Der zentrale Bereich kann entlang der Lateralachse eine Breite von 200 mm bis 300 mm aufweisen. Der zentrale Bereich kann entlang der Längsachse eine Länge von 200 mm bis 300 mm aufweisen.

Ein lateraler Randbereich kann eine Breite entlang der Lateralachse aus einem Bereich von 10 mm bis 100 mm aufweisen. Ein lateraler Randbereich kann eine Länge entlang der Längsachse aus einem Bereich von 200 mm bis 300 mm aufweisen. Die Längen des zentralen Bereichs und des lateralen Bereichs entlang der Längsachse können gleich sein.

Der innenliegende Abschnitt der Gehäusewand ist in dem zentralen Bereich des Gehäuses angeordnet. Es ist möglich, dass der innenliegende Abschnitt der Gehäusewand an einer longitudinalen Stirnseite angeordnet ist.

Es kann möglich sein, dass Kühlkörper aufgrund von Montageanforderungen der Montage am Fahrzeug nicht in Bereichen der Außenseite des Gehäuses angeordnet werden können, die unmittelbar benachbart zu Bereichen des Innenvolumens sind, in denen Elemente angeordnet sind, die, insbesondere während eines Betriebes oder beim Empfang des magnetischen Feldes, thermische Energie erzeugen.

Insgesamt ergibt sich in vorteilhafter Weise eine ausreichende Kühlung der Randbereiche, wenn das Gehäuse zur Montage am Fahrzeug in diesen Randbereichen am Fahrzeug anliegt und somit kein Bauraum für Kühlkörper an einer Außenseite des Gehäuses in diesen Randbereichen zur Verfügung steht.

In einer weiteren Ausführungsform weist der mindestens eine Kühlkörper mindestens eine Kühlrippe oder einen Kühlpin auf oder ist als solche/r ausgebildet.

Eine Kühlrippe kann hierbei einen rechteckigen Querschnitt aufweisen. Ferner kann eine Kühlrippe senkrecht von einem außenliegenden Abschnitt der Gehäusewand abstehen. Ein Kühlpin kann hierbei einen kreisförmigen oder ovalen Querschnitt aufweisen. Auch der Kühlpin kann senkrecht von dem außenliegenden Abschnitt der Gehäusewand abstehen. Vorzugsweise kann der Kühlkörper mehrere Kühlrippen oder Kühlpins aufweisen.

Hierdurch wird in vorteilhafter Weise eine große Oberfläche des Kühlkörpers zur Wärmeabgabe bereitgestellt.

Weiter umfasst die Empfangsvorrichtung mindestens ein magnetisch leitfähiges Element. Das magnetisch leitfähige Element kann insbesondere ein Ferritelement sein. Das Ferritelement kann in oder auf einer Sekundärwindungsstruktur der Empfangsvorrichtung angeordnet sein. Weiter ist das magnetisch leitfähige Element in dem Innenvolumen angeordnet. Das magnetisch leitfähige Element dient zur Führung eines magnetischen Flusses des elektromagnetischen Feldes zur Leistungsübertragung, insbesondere um eine möglichst gute magnetische Kopplung zwischen einer Primärwindungsstruktur und der Sekundärwindungsstruktur zu erreichen.

Weiter liegt das magnetisch leitfähige Element, insbesondere eine Oberfläche des magnetisch leitfähigen Elements, an einem innenliegenden Abschnitt der Gehäusewand an. Alternativ ist das magnetisch leitfähige Element thermisch mit dem innenliegenden Abschnitt verbunden, insbesondere über ein thermisch leitfähiges Element, wobei das thermisch leitfähige Element von Luft verschieden sein kann. Der innenliegende Abschnitt der Gehäusewand kann insbesondere ein innenliegender Abschnitt des Deckelteils sein.

Weiter ist der mindestens eine Kühlkörper in einem außenliegenden Abschnitt der Gehäusewand angeordnet, der ein dem innenliegenden Abschnitt gegenüberliegender Abschnitt ist. Nicht erfindungsgemäß wird beschrieben, dass der mindestens eine Kühlkörper in einem außenliegenden Abschnitt der Gehäusewand angeordnet ist, der dem innenliegenden Abschnitt nicht gegenüberliegt. In diesem Fall können der innenliegenden Abschnitt und der Kühlkörper über das Deckelteil thermisch verbunden sein.

Das magnetisch leitfähige Element kann sich, insbesondere beim Empfang des magnetischen Feldes, erwärmen. Durch die beschriebene Anordnung wird in vorteilhafter Weise eine zuverlässige Übertragung einer vergleichsweise hohen thermischen Energiemenge von dem magnetisch leitfähigen Element über einen vergleichsweise kleinen Abschnitt der Gehäusewand zu dem mindestens einen Kühlkörper und somit zum Außenvolumen ermöglicht.

Das magnetisch leitfähige Element ist in einem zentralen Bereich des Gehäuses angeordnet, nämlich zwischen zwei lateralen Randbereichen des Gehäuses. Auch die Sekundärwindungsstruktur ist in dem zentralen Bereich angeordnet. Insbesondere können die Randbereiche entlang der Lateralachse der Empfangsvorrichtung neben dem magnetisch leitfähigen Element oder neben der Sekundärwindungsstruktur angeordnet sein. In diesem Fall ist also auch der Kühlkörper in einem zentralen Abschnitt des Gehäuses, insbesondere des Deckelteils, angeordnet.

In einer weiteren Ausführungsform ist zwischen dem magnetisch leitfähigen Element und dem innenliegenden Abschnitt mindestens ein thermisch leitfähiges Element angeordnet. Das thermisch leitfähige Element weist insbesondere eine thermische Leitfähigkeit auf, die größer als die thermische Leitfähigkeit von Luft ist. Das thermisch leitfähige Element kann insbesondere ein Wärmeleitpad sein.

Hierdurch wird in vorteilhafter Weise eine gute Wärmeübertragung vom magnetisch leitfähigen Element hin zum Kühlkörper ermöglicht.

In einer weiteren Ausführungsform besteht ein thermisch leitfähiges Element aus Silikon. Insbesondere kann das thermisch leitfähige Element zwischen das magnetisch leitfähige Element und den innenliegenden Abschnitt der Gehäusewand gepresst sein. Besteht das thermisch leitfähige Element aus Silikon, so kann dieses gleichzeitig zur räumlichen Fixierung des magnetisch leitfähigen Elements im Innenvolumen sowie zur Federung und/oder Dämpfung von erschütterungsbedingten Bewegungen des magnetisch leitfähigen Elements dienen. Somit wird in vorteilhafter Weise zusätzlich die Gefahr einer Beschädigung des magnetisch leitfähigen Elements durch Vibrationen reduziert.

In einer weiteren Ausführungsform ist das thermisch leitfähige Element zusätzlich als Klebeelement ausgebildet. Beispielsweise kann das thermisch leitfähige Element einseitig oder doppelseitig klebend ausgebildet sein. Hierzu kann eine oder können gegenüberliegende Oberflächen des thermisch leitfähigen Elements mit einer Klebeschicht versehen sein. In diesem Fall ergibt sich einerseits in vorteilhafter Weise eine stabile mechanische Befestigung des thermisch leitfähigen Elements an dem magnetisch leitfähigen Element. Alternativ oder kumulativ können durch das thermisch leitfähige Element weitere Elemente der Empfangsvorrichtung im Innenvolumen fixiert werden. Beispielsweise kann das thermisch leitfähige Element in diesem Fall zur Fixierung eines Signalverbindungsmittels, beispielsweise eines (Flachband-)Kabels oder einer flexiblen Leiterplatte, an dem innenliegenden Abschnitt der Gehäusewand durch Ankleben dienen. Hierdurch können in vorteilhafter Weise einerseits Bauraumerfordernisse der Empfangsvorrichtung minimiert und andererseits eine gewünschte Wärmeübertragung von dem magnetisch leitfähigen Element zum Kühlkörper gewährleistet werden.

Erfindungsgemäß ist das Wärmeübertragungselement als Wärmerohr ausgebildet. Das Wärmerohr ist in einer Führungsnut des Deckelteils angeordnet. Hierdurch ergibt sich in vorteilhafter Weise eine möglichst effektive Übertragung von thermischer Energie. Es wird auch das Wort Wärmeleitrohr anstelle des Wortes Wärmerohr verwendet.

In einer weiteren Ausführungsform ist das Wärmerohr derart im Innenvolumen angeordnet, dass ein Gradient der Umgebungstemperatur des Wärmerohrs entlang des Verlaufs von dem ersten vorbestimmten räumlichen Bereich zu dem innenliegenden Abschnitt negativ ist. Im Innenvolumen können Elemente angeordnet sein, die thermische Energie erzeugen können. Vorzugsweise verläuft das Wärmerohr derart, dass es an Bereichen vorbei (und somit nicht durch diese Bereiche hindurch) geführt wird, in die thermische Energie von diesen Elementen abgegeben wird. Beispielsweise kann das Wärmerohr derart verlaufen, dass es nicht entlang der Vertikalachse der Empfangsvorrichtung über weiteren elektrischen und/oder elektronischen Elementen verläuft, die insbesondere bei deren Betrieb thermische Energie abgeben.

Hierdurch ergibt sich in vorteilhafter Weise eine zuverlässige Abfuhr von thermischer Energie aus dem ersten vorbestimmten räumlichen Bereich, da diese nicht durch Zufuhr von thermischer Energie in weiteren Bereichen des Wärmerohrs gestört wird.

In einer weiteren Ausführungsform umfasst die Empfangsvorrichtung mindestens eine Leiterplatte, wobei auf der mindestens einen Leiterplatte mindestens ein elektrisches oder elektronisches Element angeordnet ist. Die erste Leiterplatte oder das mindestens eine elektrische oder elektronische Element ist in dem vorbestimmten räumlichen Bereich, also beispielsweise in dem lateralen Randbereich, angeordnet. Das elektronische Element kann insbesondere ein leistungselektronisches Bauteil sein. Insbesondere kann das elektronische Element ein Bauteil einer Gleichrichterschaltung der Empfangsvorrichtung sein, wobei die Empfangsvorrichtung diese Gleichrichterschaltung umfasst. Alternativ kann ein elektrisches Element ein Kondensator oder eine Diode sein. Der Kondensator kann hierbei Teil einer Kompensationsschaltung der Empfangsvorrichtung zur Einstellung einer Reaktanz sein. Die Diode kann ebenfalls Teil der Gleichrichterschaltung sein.

Hierdurch ergibt sich in vorteilhafter Weise eine zuverlässige Kühlung von Elementen, die im Betrieb thermische Energie erzeugen, wodurch wiederum ein zuverlässiger Betrieb der Elemente gewährleistet wird.

In einer weiteren Ausführungsform ist/sind die erste Leiterplatte und/oder das mindestens eine elektrische oder elektronische Element über mindestens ein Thermal-Vias thermisch mit dem Wärmeübertragungselement verbunden. Hierdurch ergibt sich in vorteilhafter Weise eine gute und zuverlässige Übertragung thermischer Energie von dem mindestens einen elektrischen oder elektronischen Element zu dem Wärmeübertragungselement.

In einer weiteren Ausführungsform ist/sind die erste Leiterplatte und/oder das mindestens eine elektrische oder elektronische Element über mindestens ein weiteres thermisch leitfähiges Element thermisch mit dem Wärmeübertragungselement verbunden, wobei das thermisch leitfähige Element elektrisch nicht leitfähig ist. Das weitere thermisch leitfähige Element kann insbesondere ein weiteres Wärmeleitpad sein.

Das weitere thermisch leitfähige Element, insbesondere das weitere Wärmeleitpad, kann z.B. aus Keramik bestehen oder Keramik umfassen. Insbesondere kann das weitere thermisch leitfähige Element aus Aluminiumnitrit bestehen oder Aluminiumnitrit umfassen.

Weiter kann/können die erste Leiterplatte und/oder das mindestens eine elektrische oder elektronische Element über mindestens eine thermisch leitfähige Platte thermisch mit dem Wärmeübertragungselement verbunden sein. Diese Platte kann insbesondere eine Kupferplatte sein.

Somit kann die erste Leiterplatte und/oder das mindestens eine elektrische oder elektronische Element über das mindestens eine Thermal-Vias und/oder das mindestens eine weitere thermisch leitfähige Element und/oder die thermisch leitfähige Platte thermisch mit dem Wärmeübertragungselement verbunden sein. Zwischen den Elementen der thermischen Verbindung kann auch ein thermisch leitfähiges Verbindungsmaterial angeordnet sein, z.B. eine Thermopaste. Auch können die Elemente der thermischen Verbindung mechanisch verbunden sein. Beispielsweise kann die thermisch leitfähige Platte mit dem Wärmeübertragungselement verlötet sein.

Vorzugsweise ist die erste Leiterplatte und/oder das mindestens eine elektrische oder elektronische Element über das mindestens eine Thermal-Vias mit dem mindestens einen weiteren thermisch leitfähigen Element thermisch verbunden, wobei das weitere thermisch leitfähige Element mit der thermisch leitfähige Platte thermisch verbunden ist, wobei die thermisch leitfähige Platte thermisch mit dem Wärmeübertragungselement verbunden ist.

Weiter vorgeschlagen wird ein Verfahren zur Herstellung einer Empfangsvorrichtung für ein System zur induktiven Leistungsübertragung, wobei als Gehäuseteile eines Gehäuses der Empfangsvorrichtung ein Bodenteil und ein Deckelteil bereitgestellt werden. Weiter weist mindestens eines der Gehäuseteile an einer Außenseite mindestens einen Kühlkörper auf oder bildet diesen aus.

Mittels des Verfahrens kann eine Empfangsvorrichtung gemäß einer der in dieser Offenbarung erläuterten Ausführungsformen hergestellt werden. Somit kann das Verfahren alle Schritte umfassen, um eine solche Empfangsvorrichtung herzustellen.

Weiter beschrieben wird ein Fahrzeug, wobei das Fahrzeug eine Empfangsvorrichtung gemäß einer der in dieser Erfindung beschriebenen Ausführungsformen umfasst. Die Empfangsvorrichtung kann hierbei an dem Fahrzeug, insbesondere im Bereich einer Unterseite, befestigt sein.

Die Empfangsvorrichtung kann daten- und/oder signaltechnisch mit einem Kommunikationssystem des Fahrzeugs, beispielsweise einem Bussystem, verbunden werden. Weiter kann die Empfangsvorrichtung elektrisch mit einem elektrischen System des Fahrzeugs, insbesondere einem Traktionsnetz, verbunden werden. Somit kann der Empfangsvorrichtung bereitgestellte elektrische Energie, die induktionsbasiert bereitgestellt wird, an das Fahrzeug übertragen werden.

Die Erfindung wird anhand eines Ausführungsbeispiels näher erläutert. Die Figuren zeigen:
- Fig. 1: einen schematischen Querschnitt durch eine erfindungsgemäße Empfangsvorrichtung,
- Fig. 2: einen schematischen Querschnitt durch ein Deckelteil,
- Fig. 3: eine schematische Draufsicht auf ein Deckelteil,
- Fig. 4: eine schematische Unteransicht eines Deckelteils,
- Fig. 5: eine schematische Draufsicht auf ein Bodenteil,
- Fig. 6: einen schematischen Längsschnitt durch ein Bodenteil,
- Fig. 7: eine schematische Draufsicht auf ein Deckelteil in einer weiteren Ausführungsform,
- Fig. 8: eine Detailansicht eines schematischen Längsschnitts durch ein Deckelteil,
- Fig. 9a: eine schematische Draufsicht auf ein Deckelteil und
- Fig. 9b: eine Detailansicht eines schematischen Längsschnittes durch das in Fig. 9a dargestellte Deckelteil.

Nachfolgend bezeichnen gleiche Bezugszeichen Elemente mit gleichen oder ähnlichen technischen Merkmalen.

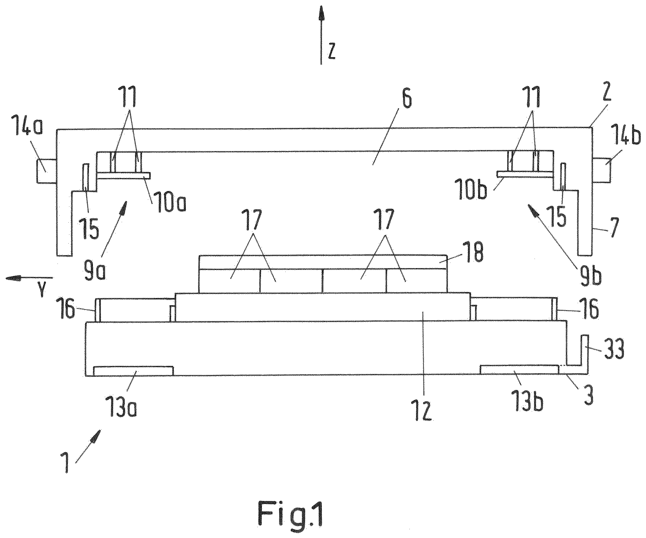

Fig. 1 zeigt einen schematischen Querschnitt durch eine Empfangsvorrichtung 1 eines Systems zur induktiven Energieübertragung. Die Empfangsvorrichtung 1 umfasst ein Gehäuse, wobei das Gehäuse einen Deckelteil 2 und einen Bodenteil 3 umfasst. Das Deckelteil 2 besteht aus Aluminium. Das Bodenteil 3 besteht aus Kunststoff, insbesondere aus glasfaserverstärktem Kunststoff. Hierbei kann das Material des Bodenteils 3, insbesondere also der glasfaserverstärkte Kunststoff, einen thermischen Ausdehnungskoeffizienten aufweisen, der gleich dem thermischen Ausdehnungskoeffizienten des Materials des Deckelteils 2 ist oder nicht mehr als ein vorbestimmtes Maß von diesem abweicht.

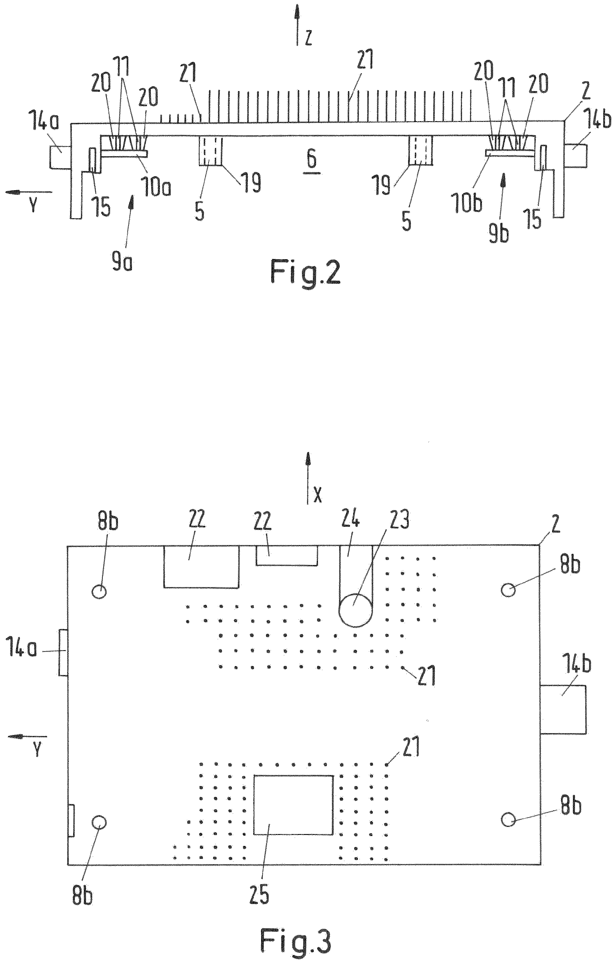

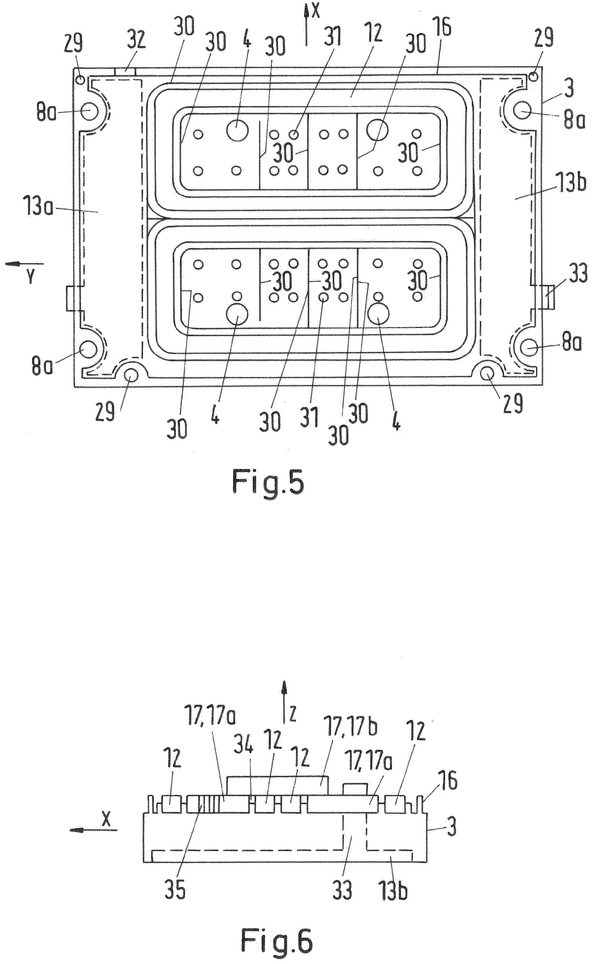

Das Bodenteil 3 kann an dem Deckelteil 2 befestigt werden, wodurch ein geschlossener Zustand des Gehäuses oder der Empfangsvorrichtung 1 hergestellt wird. Insbesondere kann das Bodenteil 3 mit dem Deckelteil 2 verschraubt werden. Um eine solche Schraubverbindung bereitzustellen, kann das Bodenteil 3 Durchgangslöcher 4, 29 (siehe Fig. 5) und das Deckelteil korrespondierende Gewindeabschnitte 5, 27 (siehe Fig. 2) aufweisen. Im geschlossenen Zustand ist das Bodenteil 3 vollständig in einem Innenvolumen 6 des Deckelteils 2 angeordnet. Seitenwände 7 des Deckelteils 2 umfassen im geschlossenen Zustand Seiten des Bodenteils 3. Alternativ oder kumulativ kann das Deckelteil 2 mit dem Bodenteil 3 verklebt werden.

Die Empfangsvorrichtung kann an einem Fahrzeug (nicht dargestellt) befestigt werden. Insbesondere kann die Empfangsvorrichtung 1 mit dem Fahrzeug verschraubt werden, insbesondere mit einem Vorderachsträger des Fahrzeugs. Um eine solche Schraubverbindung bereitzustellen, können das Bodenteil 3 und das Deckelteil 2 zueinander korrespondierende Durchgangslöcher 8a, 8b (siehe Fig. 5 und Fig. 3) aufweisen, wobei eine Schraube sich durch die korrespondierenden Durchgangslöcher 8a, 8b des Deckelteils 2 und des Bodenteils 3 im geschlossenen Zustand erstrecken kann. Weiter kann sich die Schraube in einen Gewindeabschnitt des Fahrzeugs erstrecken. Alternativ kann das Deckelteil 2 über mindestens eine Schraubverbindung mit dem Fahrzeug verschraubt werden, z.B. mit dem Vorderachsträger des Fahrzeugs. Weiter kann das Bodenteil 3 mit dem Deckelteil 2 verbunden, insbesondere verschraubt, werden.

Weiter gezeigt ist, dass die Empfangsvorrichtung, insbesondere das Deckelteil 2, einen ersten Aufnahmebereich 9a und einen zweiten Aufnahmebereich 9b aufweist. Die Aufnahmebereiche 9a, 9b sind räumliche Teilbereiche eines Innenvolumens des Gehäuses im geschlossenen Zustand.

Im Folgenden kann das folgende Referenzkoordinatensystem verwendet werden. Eine Vertikalachse z der Empfangsvorrichtung kann orthogonal zu einer ebenen Oberfläche des Deckelteils 2 oder zu einer ebenen Bodenfläche des Bodenteils 3 orientiert sein. Ist die Empfangsvorrichtung 1 an dem Fahrzeug befestigt, was auch als montierter Zustand bezeichnet werden kann, so kann die Vertikalachse z parallel zu einer Gierachse oder Vertikalachse des Fahrzeuges orientiert sein. Weiter kann eine vertikale Richtung parallel zu einer Hauptrichtung der induktiven Leistungsübertragung orientiert sein. Weiter ist eine Lateralachse y der Empfangsvorrichtung dargestellt, wobei die Lateralachse y senkrecht zur vertikalen Achse z orientiert ist. Im montierten Zustand kann die Lateralachse y parallel zu einer Nickachse oder Lateralachse des Fahrzeugs orientiert sein. Fig. 3 zeigt eine Längsachse x der Empfangsvorrichtung. Die Längsachse x ist orthogonal zu der Vertikalachse z und Lateralachse y orientiert. Im montierten Zustand kann die Längsachse x parallel zu einer Rollachse oder Längsachse des Fahrzeugs orientiert sein. Weiter kann die Längsachse x entgegengesetzt zu einer Fahrtrichtung des Fahrzeugs bei Geradeausfahrt orientiert sein.

Weiter sind eine Vertikalrichtung, eine Lateralrichtung und eine Längsrichtung jeweils durch Richtungspfeile dargestellt.

Im befestigten Zustand der Empfangsvorrichtung 1 ist das Deckelteil 2 auf dem Bodenteil 3 montiert.

Weiter ist dargestellt, dass der erste Aufnahmebereich 9a an einem ersten lateralen Randbereich der Empfangsvorrichtung 1, insbesondere des Deckelteils 2, angeordnet ist. Der zweite Aufnahmebereich 9b ist in einem zweiten lateralen Randbereich angeordnet. Die Randbereiche sind hierbei an gegenüberliegenden Enden der Empfangsvorrichtung 1 mit Bezug auf die Lateralachse y angeordnet.

Ein Aufnahmebereich 9a, 9b kann z.B. durch eine Vertiefung in der Empfangsvorrichtung, insbesondere im Deckelteil 2, gebildet werden. Alternativ oder kumulativ kann ein Aufnahmebereich 9a, 9b durch Befestigungsmittel zur Befestigung einer Leiterplatte 10a, 10b an der Empfangsvorrichtung 1 festgelegt sein, insbesondere zur Befestigung an dem Deckelteil 2.

Weiter dargestellt ist, dass die Empfangsvorrichtung 1 eine erste Leiterplatte 10a und eine zweite Leiterplatte 10b umfasst. Die erste Leiterplatte 10a ist in dem ersten Aufnahmebereich 9a angeordnet. Weiter ist die erste Leiterplatte 10a an dem Deckelteil 2 befestigt. Weiter ist die zweite Leiterplatte 10b in dem zweiten Aufnahmebereich 9b angeordnet. Weiter ist die zweite Leiterplatte 10b an dem Deckelteil 2 befestigt.

Insbesondere können die Leiterplatten 10a, 10b mit dem Deckelteil 2 verschraubt sein. Um eine solche Schraubverbindung bereitzustellen, können sich Schrauben 11 durch Durchgangslöcher der Leiterplatten 10a, 10b (nicht dargestellt) in Gewindeabschnitte des Deckelteils 2 erstrecken. Die mechanische Verbindung zwischen den Leiterplatten 10a, 10b und dem Deckelteil 2 kann hierbei auch eine elektrische Verbindung zwischen den Leiterplatten 10a, 10b und dem Deckelteil 2 bereitstellen, insbesondere um eine Erdung der Leiterplatten 10a, 10b zu ermöglichen.

Es ist möglich, dass das Deckelteil 2 elektrisch mit einem Referenzpotential, beispielsweise einem Massepotential, des Fahrzeugs verbunden ist. In diesem Fall kann die elektrische Verbindung der Leiterplatten 10a, 10b mit dem Deckelteil 2 ebenfalls eine elektrische Verbindung der Leiterplatten 10a, 10b zum Referenzpotential bereitstellen. Die elektrische Verbindung zwischen dem Deckelteil 2 und dem Referenzpotential des Fahrzeugs kann hierbei durch die mechanische Verbindung zwischen der Empfangsvorrichtung und dem Fahrzeug, insbesondere durch die Schrauben zur Befestigung der Empfangsvorrichtung 1 an dem Fahrzeug, bereitgestellt werden.

Im geschlossenen Zustand des Gehäuses oder im montierten Zustand der Empfangsvorrichtung sind die Aufnahmebereiche 9a, 9b seitlich oder neben einer Windungsstruktur 12 (siehe Fig. 5) zum Empfang des elektromagnetischen Wechselfeldes zur Leistungsübertragung mit Bezug auf die laterale Richtung angeordnet. Die Windungsstruktur 12 kann in einem zentralen Abschnitt des Innenvolumens des Gehäuses im geschlossenen Zustand angeordnet sein.

Weiter dargestellt ist, dass die Empfangsvorrichtung ein erstes magnetisches Schirmelement 13a und ein zweites magnetisches Schirmelement 13b umfasst. Ein magnetisches Schirmelement bezeichnet hierbei ein Element zur Abschirmung des magnetischen Felds. Die magnetischen Schirmelemente 13a, 13b können als Aluminiumplatten ausgebildet sein. Weiter können die magnetischen Schirmelemente 13a, 13b an dem Bodenteil 3 befestigt sein. Insbesondere können die magnetischen Schirmelemente 13a, 13b in Vertiefungen an einer Bodenseite des Bodenteils angeordnet sein. Weiter kann eine Unterseite der magnetischen Schirmelemente 13a, 13b bündig mit einer Unterseite des Bodenteils 3 angeordnet sein. Das erste magnetische Schirmelement 13a deckt den ersten Aufnahmebereich 9a vollständig von unten ab. Mit anderen Worten ist das erste magnetische Schirmelement 13a unterhalb des ersten Aufnahmebereichs 9a mit Bezug auf die vertikale Richtung angeordnet. Weiter ist das erste magnetische Schirmelement 13a derart angeordnet, dass der erste Aufnahmebereich 9a, insbesondere die erste Leiterplatte 10a, die im ersten Aufnahmebereich 9a angeordnet ist, vollständig von unten von einem magnetischen Feld abgeschirmt ist. Somit ergibt sich, dass eine Menge von magnetischen Feldlinien, die sich durch die Aufnahmebereiche 9a, 9b erstrecken, wenn ein elektromagnetisches Wechselfeld zur Leistungsübertragung bereitgestellt wird, minimiert oder sogar auf Null reduziert wird. Die magnetischen Schirmelemente 13a, 13b sind derart angeordnet, dass eine Wechselwirkung von elektrischen und/oder elektronischen Elementen, insbesondere Elementen der Leiterplatten 10a, 10b, mit dem elektromagnetischen Feld zur Leistungsübertragung minimiert werden.

Die erste Leiterplatte 10a kann auch als Niedrigspannungs-Leiterplatte bezeichnet werden. Dies kann bedeuten, dass elektrische und elektronische Komponenten der ersten Leiterplatte 10a mit einer Maximalspannung von 12 V oder 42 V versorgt werden können oder eine solche Spannung bereitstellen. Die zweite Leiterplatte 10b kann auch als Hochspannungs-Leiterplatte bezeichnet werden. Dies kann bedeuten, dass elektrische und elektronische Komponenten der zweiten Leiterplatte 10b mit einer Maximalspannung von bis zu 1.200 V versorgt werden können oder eine solche Spannung bereitstellen.

So können Komponenten der ersten Leiterplatte 10a Steuerungsmittel zur Steuerung eines Betriebes der Empfangsvorrichtung 1 und Kommunikationsmittel zur Bereitstellung einer Kommunikation mit dem Fahrzeug und/oder einer Primäreinheit bereitstellen. Komponenten der zweiten Leiterplatte 10b können eine gewünschte Gleichspannung der Empfangsvorrichtung 1 aus der Wechselspannung bereitstellen, die in der Windungsstruktur 12 durch das elektromagnetische Feld zur Leistungsübertragung induziert wird.

Weiter dargestellt ist ein erster Stecker 14a, durch den eine Signal- und eine Datenverbindung zu Komponenten der ersten Leiterplatte 10a hergestellt werden kann. Der erste Stecker 14a kann z.B. als CAN-Stecker ausgebildet sein. Zumindest ein Teil des ersten Steckers 14a ist hierbei an einer äußeren Oberfläche einer Seitenwand des Deckelteils 2 angeordnet. Weiter dargestellt ist ein zweiter Stecker 14b, der auch als Leistungsstecker oder Gleichspannungs-Schnittstelle bezeichnet werden kann. Durch den zweiten Stecker 14b kann eine Verbindung zur Leistungsübertragung und, gegebenenfalls, zur Signalübertragung zwischen Komponenten der zweiten Leiterplatte 10b und dem Fahrzeug hergestellt werden. Der zweite Stecker 14b kann ebenfalls an einer äußeren Oberfläche einer Seitenwand des Deckelteils angeordnet sein. Der zweite Stecker 14b kann ein Stecker mit Kabelverschraubung sein, um die Abdichtung des Innenvolumens des Gehäuses im geschlossenen Zustand zu gewährleisten.

Weiter dargestellt ist eine Nut 15 einer Feder-Nut-Verbindung. Die Nut 15 ist hierbei in einem Randbereich des Deckelteils 2 angeordnet. Insbesondere ist die Nut 15 eine umlaufende Nut. Die Nut 15 dient zur Aufnahme eines Dichtelements, insbesondere eines umlaufenden Dichtelements (nicht dargestellt).

Das Bodenteil 3 weist eine korrespondierende Feder 16 der Nut-Feder-Verbindung auf. Die Feder 16 ist in einem Randbereich des Bodenteils 3 und an einer Oberseite des Bodenteils 3 angeordnet. Insbesondere wird die Feder 16 durch einen Steg bereitgestellt, der von der Oberseite des Bodenteils 3 absteht.

Im geschlossenen Zustand des Gehäuses erstreckt sich die Feder 16 in die Nut 15 und verklemmt das Dichtelement in der Nut 15. Auf diese Weise kann eine robuste und zuverlässige Abdichtung des Innenvolumens des Gehäuses, in dem die Leiterplatten 10a, 10b und die Windungsstruktur 12 angeordnet sind, hergestellt werden. Auch die Feder 16 kann als umlaufende Feder ausgebildet sein.

Weiter dargestellt sind Ferritstäbe 17, die Teil einer Ferritanordnung sind, und magnetisch leitfähige Elemente bereitstellen. Hierbei ist dargestellt, dass die Ferritstäbe 17 in und auf der Windungsstruktur 12, insbesondere über einem zentralen Abschnitt der Windungsstruktur 12, angeordnet sind. Die Ferritstäbe 17 und die Windungsstruktur 12 können an dem Bodenteil 3 befestigt sein. Insbesondere können die Windungsstruktur 12 und die Ferritstäbe 17 mit dem Bodenteil 3 vergossen sein. Die Ferritstäbe 17 können derart angeordnet sein, dass ein gewünschter Verlauf von Feldlinien des magnetischen Feldes hergestellt wird.

Es ist möglich, dass hierbei obere Ferritstäbe 17b (siehe Fig. 6) nicht vollständig vergossen bzw. mit Vergussmaterial übergossen werden. Hierdurch ergibt sich in vorteilhafter Weise eine definierte Höhe der Ferritstabanordnung, da keine Höhenabweichung durch Vergussmaterial entsteht. Vorzugsweise werden jedoch untere Ferritstäbe 17a sowie der Verbindungsbereich zwischen den oberen und unteren Ferritstäben 17a, 17b vollständig vergossen.

Entlang einer Oberseite der oberen Ferritstäbe 17b kann ein Klebeband geführt werden, um die oberen Ferritstäbe 17b an den unteren Ferritstäben 17a oder an dem Bodenteil 3 zu befestigen. Hierdurch kann in vorteilhafter Weise ein Splittern der oberen Ferritstäbe 17a bei Vibrationen verhindert werden.

Weiter dargestellt ist ein Wärmeleitpad 18, welches ein wärmeleitfähiges Element bildet. Das Wärmeleitpad 18 ist auf den Ferritstäben 17, insbesondere auf den oberen Ferritstäben 17a, angeordnet. Das Wärmeleitpad 18 kann eine hohe thermische Leitfähigkeit aufweisen. Im geschlossenen Zustand des Gehäuses kann das Wärmeleitpad einen innenliegenden Abschnitt einer Gehäusewand und die Ferritstäbe 17 kontaktieren und somit eine thermische Verbindung zwischen den Ferritstäben 17 und dem Deckelteil 2 herstellen. Das Wärmeleitpad 18 kann Silikon umfassen.

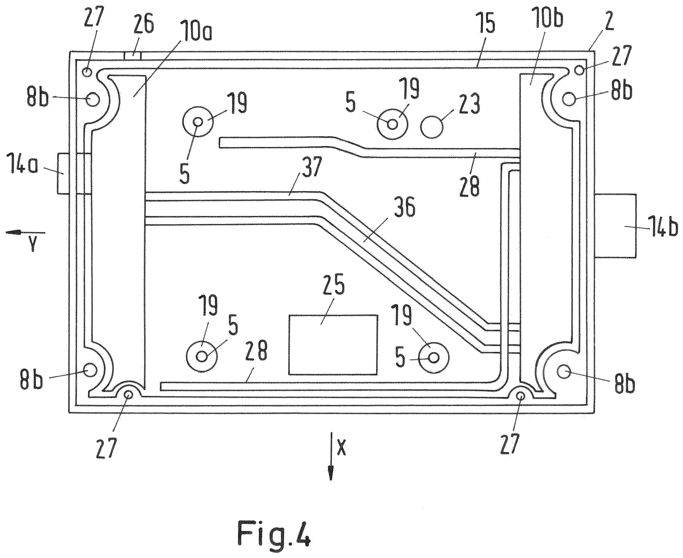

Weiter kann das Wärmeleitpad 18 ein Klebeelement bereitstellen. Es ist z.B. möglich, dass das Wärmeleitpad als doppelseitiges Klebeelement oder einseitiges Klebeelement ausgebildet ist. Somit kann das Wärmeleitpad 18 genutzt werden, um ein Flachbandkabel 36 in einer Aufnahmenut 37 des Deckelteils 2 (siehe Fig. 4) zu sichern.

Mit anderen Worten kann die Empfangsvorrichtung 1 zumindest ein wärmeleitfähiges Element umfassen, wobei das wärmeleitfähige Element eine thermische Verbindung zwischen dem Deckelteil 2 und der Windungsstruktur 12 oder einer Ferritanordnung in einem geschlossenen Zustand des Gehäuses herstellt. Insbesondere kann das wärmeleitfähige Element das Deckelteil 2 und die Windungsstruktur 12 oder die Ferritanordnung mechanisch kontaktieren.

Fig. 2 zeigt einen schematischen Querschnitt durch ein Deckelteil 2. Dargestellt sind die Leiterplatten 10a, 10b, die an dem Deckelteil 2 durch Schrauben 11 befestigt sind. Weiter dargestellt ist die Nut 15 der Nut-Feder-Verbindung. Weiter dargestellt sind zylinderförmige Erhebungen 19 auf einer Unterseite des Deckelteils 2, die einen Gewindeabschnitt zur Aufnahme der Schrauben 11 zur Befestigung des Bodenteils 3 an dem Deckelteil 2 umfassen.

Weiter dargestellt sind konische Erhebungen 20 des Deckelteils 2, insbesondere an einer Unterseite des Deckelteils 2, die sich in das Innenvolumen 6 des Deckelteils 2 erstrecken und die Gewinde für die Schrauben 11 zur Befestigung der Leiterplatten 10a, 10b an dem Deckelteil 2 bereitstellen. Diese konischen Erhebungen 20 sind jeweils in den Aufnahmebereichen 9a, 9b angeordnet und erstrecken sich durch Durchgangslöcher in den Leiterplatten 10a, 10b (nicht dargestellt). Dies erlaubt in vorteilhafter Weise das Ausrichten der Leiterplatten 10a, 10b in dem entsprechenden Aufnahmebereich 9a, 9b. Weiter dargestellt sind Kühlstäbe 21, die an einer Oberseite des Deckelteils 2 angeordnet sind. Die Kühlstäbe 21 können unterschiedliche Längen aufweisen. Die Länge kann hierbei entsprechend von Bauraumbedingungen gewählt werden.

Die Kühlstäbe 21 können in einem zentralen Abschnitt des Deckelteils 2 angeordnet sein. Insbesondere können die Kühlstäbe 21 außerhalb von Volumina angeordnet sein, die über den Aufnahmebereichen 9a, 9b oder über den Leiterplatten 10a, 10b angeordnet sind. Die Kühlstäbe 21 ermöglichen eine Übertragung von thermischer Energie von dem Deckelteil 2 in eine Umgebung durch Konvektion.

Fig. 3 zeigt eine schematische Draufsicht auf ein Deckelteil 2. Dargestellt sind die Durchgangslöcher 8b zur Aufnahme von Schrauben, um die Empfangsvorrichtung 1 an dem Fahrzeug zu befestigen. Weiter dargestellt sind Kühlstäbe 21, die von einer Oberseite des Deckelteils 2 abstehen. Weiter dargestellt sind Vertiefungen 22 in der Oberseite des Deckelteils 2. Diese Vertiefungen 22 verringern ein Innenvolumen des Gehäuses im geschlossenen Zustand des Gehäuses. Insbesondere können die Vertiefungen 22 eine Luftmenge im Innenvolumen der Empfangsvorrichtung 1 verringern.

Dies wiederum kann eine Druckänderung eines Druckes in dem Innenvolumen aufgrund von Temperaturänderungen verringern. Es ist möglich, dass Temperaturen in der Empfangsvorrichtung 1 zwischen -40°C und 120°C variieren. Diese Temperaturänderungen können von einer Temperaturänderung der Außentemperatur und von thermischer Energie, die durch elektrische und elektronische Komponenten im Innenvolumen erzeugt wird, insbesondere von Komponenten der zweiten Leiterplatte 10b, abhängen. Die Temperaturänderungen können in einer Druckänderung des Druckes im Innenvolumen resultieren. Eine Reduktion des Innenvolumens erlaubt somit in vorteilhafter Weise die Reduktion einer Höhe der Druckänderung.

Weiter dargestellt ist ein erstes Membranelement 23. Das erste Membranelement 23 ist als semipermeables, dampfdurchlässiges Element ausgebildet. Insbesondere ermöglicht das dampfdurchlässige Membranelement 23, dass Dampf aus dem Innenvolumen der Empfangsvorrichtung in einem geschlossenen Zustand des Gehäuses durch das Membranelement 23 austreten kann. Das erste Membranelement 23 erstreckt sich durch das Deckelteil 2. Auf der Oberseite des Deckelteils 2 ist das Membranelement 23 in einer geneigten Rille 24 für einen Wasserabfluss angeordnet.

Weiter dargestellt ist ein zweites Membranelement 25. Das zweite Membranelement wird durch ein flexibles, nicht permeables, insbesondere nicht dampfdurchlässiges, Material bereitgestellt, beispielsweise durch ein Elastomer, insbesondere durch Silikon, ein thermoplastisches Elastomer oder andere Kunststoffe wie Polyvinyl-Chlorid oder EPDM (Ethylen-Propylen-Dien). Das zweite Membranelement 25 ermöglicht in vorteilhafter Weise eine Änderung des Innenvolumens der Empfangsvorrichtung 1 im geschlossenen Zustand des Gehäuses. Aufgrund der vorhergehend beschriebenen Temperaturänderungen kann ein Druck im Innenvolumen einen maximal zulässigen Druck übersteigen. Das zweite Membranelement 25 kann insbesondere derart ausgebildet sein, dass es sich bei einem Druck, der höher als ein vorbestimmter Druck ist, verformt.

Insbesondere wenn das erste Membranelement 23 keine Diffusion von Dampf aus dem Innenvolumen des Gehäuses in eine Umgebung zulässt, ermöglicht das zweite Membranelement 25 durch eine Verformung, dass der Druck im Innenvolumen in bestimmten Grenzen liegt. Eine Dampfdiffusion kann beispielsweise dann nicht möglich sein, wenn das erste Membranelement 23 mit Wasser bedeckt ist, beispielsweise wenn das Fahrzeug durch eine tiefe Pfütze fährt.

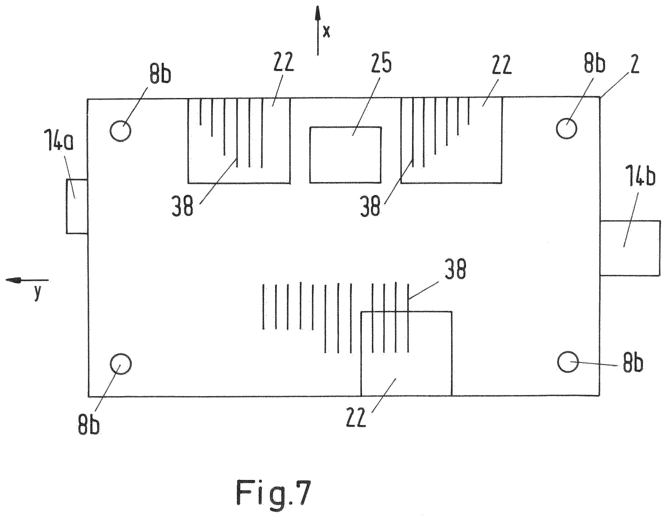

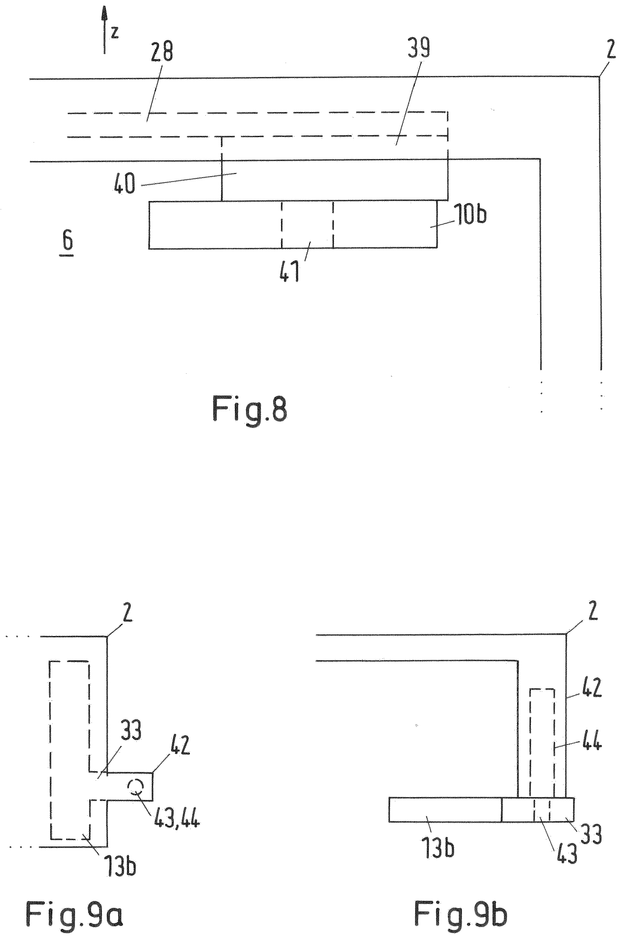

Fig. 4 zeigt eine schematische Unteransicht eines Deckelteils 2, insbesondere der in den Figuren 1 bis 3 und in den Figuren 7 bis 9a, 9b dargestellten Ausführungsformen. Dargestellt sind die Leiterplatten 10a, 10b. Ein Randbereich des Deckelteils 2, insbesondere ein Randbereich, der die erste Leiterplatte 10a einschließt, weist eine Vertiefung 26 zur Aufnahme einer Zunge 32 (siehe Fig. 5) des ersten magnetischen Schirmelements 13a auf. Die Zunge 32 verbindet das erste magnetische Schirmelement 13a mit dem Deckelteil 2 und stellt somit eine elektrische Verbindung zwischen dem ersten Schirmelement 13a und somit zu dem Referenzpotential des Fahrzeuges her.

Weiter dargestellt sind zylindrische Erhebungen 19 mit dem Gewindeabschnitt 5. Weiter dargestellt sind das erste und das zweite Membranelement 23, 25. Weiter dargestellt sind Gewindeabschnitte 27 in dem Deckelteil 2, die ein Verschrauben des Bodenteils 3 mit dem Deckelteil 2 ermöglichen. Weiter dargestellt ist die Nut 15 der Nut-Feder-Verbindung, die die Leiterplatten 10a, 10b und einen zentralen Abschnitt des Deckelteils 2 umfasst.

Weiter dargestellt ist eine Aufnahmenut 37 zur Aufnahme eines Flachbandkabels 36. Das Flachbandkabel 36 stellt eine Daten- und Signalverbindung zwischen Komponenten der ersten Leiterplatte 10a und Komponenten der zweiten Leiterplatte 10b her. Das Flachbandkabel 36 kann in der Aufnahmenut 37 durch Klebeelemente gesichert werden. Hierbei ist möglich, dass die Klebeelemente durch Wärmeleitpads 18 (siehe Fig. 1) bereitgestellt werden.

Statt des Flachbandkabels 36 kann auch eine flexible Leiterplatte zur Herstellung der Daten- und Signalverbindung verwendet werden. Die flexible Leiterplatte kann insbesondere einseitig klebend ausgeführt sein. In diesem Fall kann das Deckelteil 2 keine Aufnahmenut 37 aufweisen.

Weiter ist auch ein anderer Verlauf der in Fig. 4 dargestellten Aufnahmenut 37 und eines darin angeordneten Flachbandkabels 36 bzw. ein anderer Verlauf einer flexiblen Leiterplatte vorstellbar. So ist in Fig. 4 dargestellt, dass die Aufnahmenut 37 durch einen Bereich verläuft, in dem Ferritstäbe 17 (siehe Fig. 1) oder ein Wärmeleitpad 18 an dem Deckelteil 2 anliegen. Es ist jedoch auch vorstellbar, dass die Aufnahmenut 37 und ein darin angeordnetes Flachbandkabel 36 bzw. eine flexiblen Leiterplatte derart anzuordnen, dass diese um den Bereich herumgeführt wird, in dem die Ferritstäbe 17 bzw. das Wärmeleitpad 18 an dem Deckelteil 2 anliegt.

Weiter dargestellt sind als Wärmeleitrohre 28 ausgebildete Wärmeübertragungsmittel, wobei die Wärmeleitrohre 28 sich von der zweiten Leiterplatte 10b in den zentralen Bereich des Deckelteils 2 erstrecken. Insbesondere erstrecken sich die Wärmeleitrohre 28 von der zweiten Leiterplatte 10b in einen Bereich unterhalb der Kühlstäbe 21 (siehe Fig. 2 und Fig. 3). Die Wärmeleitrohre 28 ermöglichen eine Übertragung von thermischer Energie von der zweiten Leiterplatte 10b, insbesondere von wärmegenerierenden Komponenten der zweiten Leiterplatte 10b, wie z.B. leistungselektronischen Komponenten, in den zentralen Bereich. Somit erstreckt sich das Wärmeübertragungsmittel von einem lateralen Randbereich des Gehäuses, nämlich von dem Aufnahmebereich 9b, zu einem innenliegenden Abschnitt des Gehäuses, nämlich dem zentralen Bereich des Deckelteils.

Dies wiederum ermöglicht die Verteilung von thermischer Energie innerhalb der Empfangsvorrichtung 1, was in vorteilhafter Weise eine thermische Belastung der zweiten Leiterplatte 10b und deren Komponenten reduziert.

Die Wärmeleitrohre sind in Aufnahmenuten des Deckelteils 2, insbesondere in Aufnahmenuten in inneren Wandabschnitten des Deckelteils 2 angeordnet.

Es ist dargestellt, dass die Wärmeleitrohre 28 gekrümmte und gerade Abschnitte aufweisen. Somit kann Wärme entlang eines Pfades übertragen werden, entlang dessen ein Gradient einer Umgebungstemperatur des Wärmeleitrohrs 28 negativ ist. Insbesondere kann ein Wärmerohr 28 mit einem vorbestimmten Abstand an Ferritstäben 17 vorbeigeführt werden.

Fig. 5 zeigt eine schematische Draufsicht auf ein Bodenteil 3. Dargestellt sind die Durchgangslöcher 4 und weitere Durchgangslöcher 29 zur Bereitstellung einer Schraubverbindung zwischen dem Bodenteil 3 und dem Deckelteil 2. Weiter dargestellt sind die Durchgangslöcher 8a zur Bereitstellung einer Schraubverbindung der Empfangsvorrichtung 1 mit dem Fahrzeug. Weiter dargestellt ist die Feder 16 der Nut-Feder-Verbindung. Durch Strichlinien dargestellt sind die magnetischen Schirmelemente 13a, 13b.

Weiter dargestellt sind Stege 30, die von einer Oberseite des Bodenteils 3 abstehen. Diese Stege 30 umfassen einen Aufnahmebereich für die Windungsstruktur 12 und für die Ferritstäbe 17 (siehe Fig. 1) und legen somit den Aufnahmebereich fest. Weiter legen die Stege 30 einen Aufnahmebereich für Vergussmaterial zum Vergießen der Ferritstäbe 17 und der Windungsstruktur 12 fest. Weiter erhöhen die abstehenden Stege eine mechanische Stabilität des Bodenteils 3.

Die abstehenden Stege 30 sind in einem zentralen Bereich des Bodenteils 3 angeordnet, insbesondere in einem Bereich zwischen den Volumina über den magnetischen Schirmelementen 13a, 13b.

Weiter dargestellt sind zylinderförmige Erhebungen 31 auf einer Oberseite des Bodenteils 3. Diese Erhebungen 31 sind in den Aufnahmebereichen für die Ferritstäbe 17 angeordnet. Der Übersichtlichkeit halber sind nur zwei zylinderförmige Erhebungen 31 mit einem Bezugszeichen versehen. Diese zylinderförmigen Erhebungen 31 dienen als Abstandshalterelemente, um einen gewünschten Abstand zwischen einer Oberseite des Bodenteils 3 und einer Unterseite eines Ferritstabes 17 bereitzustellen.

Weiter dargestellt ist eine Zunge 32, die das erste magnetische Schirmelement 13a elektrisch mit dem Deckelteil 2 verbindet. Weiter dargestellt ist eine Zunge 33, die das zweite magnetische Schirmelement 13 mit dem Deckelteil 2 verbindet.

Fig. 6 zeigt einen schematischen Längsschnitt durch ein Bodenteil 3. Dargestellt ist die Nut der Nut-Feder-Verbindung zwischen dem Bodenteil 3 und dem Deckelteil 2. Weiter dargestellt ist das zweite magnetische Schirmelement 13b mit der Zunge 33.

Weiter dargestellt ist die Windungsstruktur 12, wobei die Windungsstruktur 12 durch eine vorhergehend erläuterte Doppel-D-Windungsstruktur bereitgestellt wird. Weiter dargestellt sind Ferritstäbe 17, wobei untere Ferritstäbe 17a unterhalb von einem oberen Ferritstab 17b angeordnet sind. Die Anordnung der Ferritstäbe 17a, 17b stellt eine Ausnehmung 34 zur Aufnahme eines zentralen Abschnitts der Windungsstruktur 12 bereit. Nicht dargestellt ist eine Vergussmasse für die Ferritstäbe 17a, 17b und die Windungsstruktur 12.

Weiter dargestellt ist ein Antennenelement 35, welches durch eine Antennenwindungsstruktur bereitgestellt wird, die um einen der unteren Ferritstäbe 17a gewickelt ist. Das Antennenelement 35 kann zur Herstellung einer drahtlosen Signalverbindung zwischen Komponenten der ersten Leiterplatte 10a und einer Primäreinheit dienen.

In Fig. 7 ist eine schematische Draufsicht auf ein Deckelteil 2 in einer weiteren Ausführungsform dargestellt. Im Unterschied zu der in Fig. 3 dargestellten Ausführungsform sind Kühlrippen 38 an dem Deckelteil 2 angeordnet, wobei die Kühlrippen 38 von einer Oberseite des Deckelteils 2 abstehen. Hierbei ist dargestellt, dass zumindest ein Teil der Kühlrippen 38 im Bereich von Vertiefungen 22 in der Oberseite des Deckelteils 2 angeordnet sein kann. Allerdings ist es auch möglich, dass Kühlrippen 38 vollständig innerhalb oder vollständig außerhalb dieser Vertiefungen 22 an der Oberseite des Deckelteils 2 angeordnet sein können. Weiter dargestellt ist das in der Fig. 3 dargestellten Ausführungsform beschriebene zweite Membranelement 25 sowie die Durchgangslöcher 8b zur Aufnahme von Schrauben, um die Empfangsvorrichtung 1, insbesondere das Deckelteil 2, an dem Fahrzeug zu befestigen.

Fig. 8 zeigt eine Detailansicht eines schematischen Querschnitts durch ein Deckelteil 2 in einer weiteren Ausführungsform. Dargestellt ist ein Wärmeleitrohr 28, welches in einer Aufnahmenut des Deckelteils 2 angeordnet ist. Weiter dargestellt ist eine Kupferplatte 39, die ebenfalls in einer Ausnehmung an einem inneren Wandabschnitt des Deckelteils 2 angeordnet ist. Die Kupferplatte 39 ist hierbei mit dem Wärmeleitrohr 28, insbesondere einem Endabschnitt des Wärmeleitrohrs 28 mechanisch verbunden, insbesondere verlötet. Hierdurch ist auch eine thermische Verbindung zwischen der Kupferplatte 39 und dem Wärmeleitrohr 28 gegeben.

Weiter dargestellt ist ein weiteres Wärmeleitpad 40, welches aus Aluminiumnitrit bestehen oder Aluminiumnitrit umfassen kann. Das weitere Wärmeleitpad 40 liegt hierbei an einer Unterseite der Kupferplatte 39 an. Zwischen dem weiteren Wärmeleitpad 40 und der Kupferplatte 39 kann eine Thermopaste angeordnet sein. Somit liegt das weitere Wärmeleitpad 40 an einer Oberfläche der Kupferplatte 39 an, die der Oberfläche der Kupferplatte 39 gegenüberliegt, an der das Wärmeleitrohr 28 befestigt ist. An einer Unterseite des weiteren Wärmeleitpads 40 liegt die weitere Leiterplatte 10b an. Zwischen der Unterseite des weiteren Wärmeleitpads 40 und der Oberseite der weiteren Leiterplatte 10b kann ebenfalls Thermopaste angeordnet sein. Weiter dargestellt ist schematisch ein Thermal-Vias 41, über welches elektronische Elemente, insbesondere wärmeproduzierende Elemente an der Unterseite der weiteren Leiterplatte 10b thermisch mit dem weiteren Wärmeleitpad 40 verbunden sein können.

Eine Dicke der weiteren Leiterplatte 10b kann hierbei in einem Bereich von 1.2 mm bis 1.4 mm liegen. Eine Dicke des weiteren Wärmeleitpads 40 kann hierbei in einem Bereich von 0.4 mm bis 0.6 mm liegen. Eine Dicke der Kupferplatte 39 kann in einem Bereich von 0.9 mm bis 1.1 mm liegen. Eine Dicke einer Schicht aus Thermopaste kann in einem Bereich von 0.05 mm bis 0.15 mm liegen.

In Fig. 9a ist eine Detailansicht einer Draufsicht auf ein Deckelteil 2 dargestellt. Hierbei wird dargestellt, dass das Deckelteil 2 einen auskragenden Abschnitt 42 aufweisen oder ausbilden kann, wobei der auskragende Abschnitt 42 von einem Randbereich, insbesondere einem lateralen Randbereich, des Deckelteils 2 abstehen kann. Weiter dargestellt ist das zweite magnetische Schirmelement 13b, welches eine Zunge 33 aufweist oder ausbildet. In der Zunge 33 kann eine Durchgangsöffnung 43 angeordnet sein. In dem auskragenden Abschnitt 42 des Deckelteils 2 kann ein Gewindeabschnitt 44 angeordnet sein. Somit ist es möglich, die Zunge 33 des zweiten magnetischen Schirmelements 13b über eine Schraube mit dem Deckelteil 2 elektrisch und mechanisch zu verbinden, wobei die Schraube sich durch die Durchgangsöffnung 43 der Zunge 33 in den Gewindeabschnitt 44 erstrecken kann.

In Fig. 9b ist eine Detailansicht eines schematischen Querschnitts des Deckelteils 2 mit dem zweiten magnetischen Schirmelement 13b dargestellt. Insbesondere ersichtlich sind die Zunge 33 des zweiten magnetischen Schirmelements 13b, die Durchgangsöffnung 43 in der Zunge 33 sowie der Gewindeabschnitt 44 im auskragenden Abschnitt 42 des Deckelteils 2.

Entsprechend kann auch das erste magnetische Schirmelement 13a (siehe z. B. Fig. 1) elektrisch mit dem Deckelteil 2 verbunden werden.

### Bezugszeichenliste

- 1: Empfangsvorrichtung
- 2: Deckelteil
- 3: Bodenteil
- 4: Durchgangsöffnung
- 5: Gewindeabschnitt
- 6: Innenvolumen
- 7: Seitenwände
- 8a, 8b: Durchgangsöffnung
- 9a, 9b: Aufnahmebereiche
- 10a, 10b: Leiterplatte
- 11: Schraube
- 12: Windungsstruktur
- 13a, 13b: magnetisches Schirmelement
- 14a, 14b: Stecker
- 15: Nut
- 16: Feder
- 17: Ferritstab
- 17a, 17b: Ferritstab
- 18: Wärmeleitpad
- 19: zylinderförmige Erhebung
- 20: konische Erhebung
- 21: Kühlstab
- 22: Ausnehmung
- 23: erstes Membranelement
- 24: Rille
- 25: zweites Membranelement
- 26: Nut
- 27: Gewindeabschnitt
- 28: Wärmeleitrohr
- 29: Durchgangsöffnung
- 30: Steg
- 31: zylinderförmige Erhebung
- 32: Zunge
- 33: Zunge
- 34: Ausnehmung
- 35: Antennenelement
- 36: Flachbandkabel
- 37: Aufnahmenut
- 38: Kühlrippe
- 39: Kupferplatte
- 40: weiteres Wärmeleitpad
- 41: Thermal-Vias
- 42: auskragender Abschnitt
- 43: Durchgangsöffnung
- 44: Gewindeabschnitt

## Patentansprüche

1. Empfangsvorrichtung für ein System zur induktiven Leistungsübertragung, wobei die Empfangsvorrichtung (1) ein Gehäuse umfasst, wobei das Gehäuse als Gehäuseteile einen Deckelteil (2) und einen Bodenteil (3) umfasst, wobei das Gehäuse ein Innenvolumen zur Aufnahme mindestens einer Windungsstruktur (12) aufweist,
wobei mindestens eines der Gehäuseteile an einer Außenseite mindestens einen Kühlkörper aufweist, wobei die Empfangsvorrichtung (1) mindestens ein magnetisch leitfähiges Element (17) und eine Sekundärwindungsstruktur (12) umfasst, wobei das magnetisch leitfähige Element (17) in dem Innenvolumen angeordnet ist, wobei das magnetisch leitfähige Element (17) in einem zentralen Bereich zwischen zwei lateralen Randbereichen des Gehäuses angeordnet ist, wobei das magnetisch leitfähige Element (17) an einem innenliegenden Abschnitt der Gehäusewand anliegt oder mit einem innenliegenden Abschnitt der Gehäusewand über ein thermisch leitfähiges Element thermisch verbunden ist, wobei der innenliegenden Abschnitt der Gehäusewand und der Kühlkörper in dem zentralen Bereich des Gehäuses angeordnet ist, wobei der Kühlkörper in einem außenliegenden Abschnitt der Gehäusewand angeordnet ist, der dem innenliegenden Abschnitt gegenüberliegt,
wobei die Empfangsvorrichtung (1) mindestens ein Wärmeübertragungselement (28) umfasst, wobei durch das mindestens eine Wärmeübertragungselement (28) thermische Energie von einem lateralen Randbereich im Innenvolumen zu dem innenliegenden Abschnitt der Gehäusewand übertragbar ist,
**dadurch gekennzeichnet, dass**
die Sekundärwindungsstruktur (12) in dem Innenvolumen angeordnet ist, wobei die Sekundärwindungsstruktur (12) in dem zentralen Bereich zwischen zwei lateralen Randbereichen des Gehäuses angeordnet ist, wobei das Wärmeübertragungselement (28) als Wärmerohr (28) ausgebildet ist, das in einer Führungsnut des Deckelteils (2) angeordnet ist.

2. Empfangsvorrichtung nach Anspruch 1, **dadurch gekennzeichnet, dass** der mindestens eine Kühlkörper mindestens eine Kühlrippe oder einen Kühlpin (21) aufweist.

3. Empfangsvorrichtung nach einem der vorangegangenen Ansprüche, **dadurch gekennzeichnet, dass** zwischen dem magnetisch leitfähigen Element (17) und dem innenliegenden Abschnitt mindestens ein thermisch leitfähiges Element (18) angeordnet ist.

4. Empfangsvorrichtung nach Anspruch 3, **dadurch gekennzeichnet, dass** ein thermisch leitfähiges Element (18) aus Silikon besteht.

5. Empfangsvorrichtung nach Anspruch 3 oder 4, **dadurch gekennzeichnet, dass** das thermisch leitfähige Element (18) zusätzlich als Klebeelement ausgebildet ist.

6. Empfangsvorrichtung nach einem der vorangegangenen Ansprüche, **dadurch gekennzeichnet, dass**
das Wärmerohr (28) derart im Innenvolumen angeordnet ist, dass ein Gradient der Umgebungstemperatur des Wärmerohrs (28) entlang des Verlaufs von dem ersten vorbestimmten räumlichen Bereich zu dem innenliegenden Abschnitt negativ ist.

7. Empfangsvorrichtung nach einem der vorangegangenen Ansprüche, **dadurch gekennzeichnet, dass** die Empfangsvorrichtung (1) mindestens eine Leiterplatte (10a, 10b) umfasst, wobei auf der mindestens einen Leiterplatte (10a, 10b) mindestens ein elektrisches oder elektronisches Element angeordnet ist, wobei die Leiterplatte (10a, 10b) oder das mindestens eine elektrische oder elektronische Element in dem ersten räumlichen Bereich angeordnet ist.

8. Empfangsvorrichtung nach einem der vorangegangenen Ansprüche, **dadurch gekennzeichnet, dass** die erste Leiterplatte (10a, 10b) und/oder das mindestens eine elektrische oder elektronische Element über mindestens ein Thermal-Via thermisch mit dem Wärmeübertragungselement (28) verbunden ist/sind.

9. Empfangseinrichtung nach einem der vorangegangenen Ansprüche, **dadurch gekennzeichnet**, das die erste Leiterplatte (10a, 10b) und/oder das mindestens eine elektrische oder elektronische Element über mindestens ein weiteres thermisch leitfähiges Element thermisch mit dem Wärmeübertragungselement (28) verbunden ist/sind, wobei das weitere thermisch leitfähige Element elektrisch nicht leitfähig ist.

10. Verfahren zur Herstellung einer Empfangsvorrichtung für ein System zur induktiven Leistungsübertragung, wobei als Gehäuseteile eines Gehäuses der Empfangsvorrichtung (1) ein Bodenteil (2) und ein Deckelteil (3) bereitgestellt werden, wobei mindestens eines der Gehäuseteile an einer Außenseite mindestens einen Kühlkörper aufweist oder ausbildet, wobei die Empfangsvorrichtung (1) mindestens ein magnetisch leitfähiges Element (17) und eine Sekundärwindungsstruktur (12) umfasst, wobei das magnetisch leitfähige Element (17) und die Sekundärwindungsstruktur (12) in dem Innenvolumen angeordnet sind, wobei das magnetisch leitfähige Element (17) und die Sekundärwindungsstruktur (12) in einem zentralen Bereich zwischen zwei lateralen Randbereichen des Gehäuses angeordnet sind, wobei das magnetisch leitfähige Element (17) an einem innenliegenden Abschnitt der Gehäusewand anliegt oder mit einem innenliegenden Abschnitt der Gehäusewand über ein thermisch leitfähiges Element thermisch verbunden ist, wobei der innenliegenden Abschnitt der Gehäusewand und der Kühlkörper in dem zentralen Bereich des Gehäuses angeordnet ist, wobei der Kühlkörper in einem außenliegenden Abschnitt der Gehäusewand angeordnet ist, der dem innenliegenden Abschnitt gegenüberliegt,
wobei die Empfangsvorrichtung (1) mindestens ein Wärmeübertragungselement (28) umfasst, wobei durch das mindestens eine Wärmeübertragungselement (28) thermische Energie von einem lateralen Randbereich im Innenvolumen zu dem innenliegenden Abschnitt der Gehäusewand übertragbar ist, wobei das Wärmeübertragungselement (28) als Wärmerohr (28) ausgebildet ist, das in einer Aufnahmenut des Deckelteils (2) angeordnet ist.

## Claims

1. Receiving device for a system for inductive power transfer, wherein the receiving device (1) comprises a housing, wherein the housing comprises as housing parts a cover part (2) and a base part (3), wherein the housing has an inner volume for accommodating at least one winding structure (12), at least one of the housing parts having on an outer side at least one heat sink, wherein the receiving device (1) comprises at least one magnetically conductive element (17) and a secondary winding structure (12), wherein the magnetically conductive element (17) is arranged in the inner volume, wherein the magnetically conductive element (17) is arranged in a central region between two lateral edge regions of the housing, wherein the magnetically conductive element (17) rests against an inner section of the housing wall or is connected to an inner section of the housing wall via a thermally conductive element, the inner section of the housing wall and the heat sink being arranged in the central region of the housing, wherein the heat sink is arranged in an outer section of the housing wall which is opposite the inner section, wherein the receiving device (1) comprises at least one heat transfer element (28), wherein thermal energy is transferred from a lateral edge region in the inner volume to the inner section of the housing wall through the at least one heat transfer element (28), **characterized in that** the secondary winding structure (12) is arranged in the inner volume, wherein the secondary winding structure (12) is arranged in the central region between two lateral edge regions of the housing, wherein the heat transfer element (28) is designed as a heat pipe (28), which is arranged in a guide groove of the cover part (2).

2. Receiving device according to claim 1, **characterized in that** the at least one heat sink has at least one cooling lip or a cooling pin (21).

3. Receiving device according to one of the preceding claims, **characterized in that** at least one thermally conductive element (18) is arranged between the magnetically conductive element (17) and the inner section.

4. Receiving device according to claim 3, **characterized in that** a thermally conductive element (18) consists of silicon.

5. Receiving device according to claim 3 or 4, **characterized in that** the thermally conductive element (18) is additionally designed as an adhesive element.

6. Receiving device according to one of the preceding claims, **characterized in characterized in that** the heat pipe (28) is arranged in the inner volume in such a way that a gradient of the ambient temperature of the heat pipe (28) is negative along the course from the first predetermined spatial region to the inner section.

7. Receiving device according to one of the preceding claims, **characterized in that** the receiving device (1) comprises at least one printed circuit board (10a, 10b), wherein at least one electrical or electronic element is arranged on the at least one printed circuit board (10a, 10b), wherein the printed circuit board (10a, 10b) or the at least one electrical or electronic element is arranged in the first spatial region.

8. Receiving device according to one of the preceding claims, **characterized in that** the first printed circuit board (10a, 100) and/or the at least one electrical or electronic element is thermally connected to the heat transfer element (28) via at least one thermal vias.

9. Receiving device according to one of the preceding claims, **characterized in that** the first printed circuit board (10a, 10b) and/or the at least one electrical or electronic element is thermally connected to the heat transfer element (28) via at least one further thermally conductive element, wherein the further thermally conductive element is not electrically conductive.

10. Method of manufacturing a receiving device for a system for inductive power transfer, wherein a base part (2) and a cover part (3) are provided as housing parts of a housing of the receiving device (1), wherein at least one of the housing parts has or forms at least one heat sink on an outer side, wherein the receiving device (1) comprises at least one magnetically conductive element (17) and a secondary winding structure (12), wherein the magnetically conductive element (17) and the secondary winding structure (12) are arranged in the inner volume, wherein the magnetically conductive element (17) and the secondary winding structure (12) are arranged in a central region between two lateral edge regions of the housing, wherein the magnetically conductive element (17) rests against an inner section of the housing wall or is thermally connected to an inner section of the housing wall via a thermally conductive element, wherein the inner section of the housing wall and the heat sink are arranged in the central region of the housing, wherein the heat sink is arranged in an outer section of the housing wall which is opposite the inner section, wherein the receiving device (1) comprises at least one heat transfer element (28), wherein is transferred from a lateral edge region in the inner volume to the inner section of the housing wall through the at least one heat transfer element (28) , wherein the heat transfer element (28) is designed as a heat pipe (28), which is arranged in a guide groove of the cover part (2).

## Revendications

1. Dispositif de réception pour un système de transfert de puissance inductif, dans lequel le dispositif de réception (1) comprend un boîtier, dans lequel le boîtier comprend comme parties de boîtier une partie de couvercle (2) et une partie de base (3), dans lequel le boîtier a un volume intérieur pour loger au moins une structure d'enroulement (12), au moins une des parties de boîtier ayant sur un côté extérieur au moins un dissipateur de chaleur, dans lequel le dispositif de réception (1) comprend au moins un élément magnétiquement conducteur (17) et une structure d'enroulement secondaire (12), dans lequel l'élément magnétiquement conducteur (17) est disposé dans le volume intérieur, dans lequel l'élément magnétiquement conducteur (17) est disposé dans une région centrale entre deux régions de bord latéral du boîtier, dans lequel l'élément magnétiquement conducteur (17) repose sur une section intérieure de la paroi du boîtier ou est relié à une section intérieure de la paroi du boîtier par l'intermédiaire d'un élément thermiquement conducteur, la partie intérieure de la paroi du boîtier et le dissipateur thermique sont disposés dans la zone centrale du boîtier, le dissipateur thermique étant disposé dans une partie extérieure de la paroi du boîtier opposée à la partie intérieure, le dispositif de réception (1) comprenant au moins un élément de transfert thermique (28), l'énergie thermique étant transférée d'une region de bord latéral du volume intérieur à la partie intérieure de la paroi du boîtier par l'intermédiaire d'au moins un élément de transfert thermique (28), **caractérisé en ce que** la structure d'enroulement secondaire (12) est disposée dans le volume intérieur, la structure d'enroulement secondaire (12) étant disposée dans la région centrale entre deux régions de bord latéral du boîtier, l'élément de transfert de chaleur (28) étant conçu comme un caloduc (28), qui est disposé dans une rainure de guidage de la partie de couvercle (2).

2. Dispositif de réception selon la revendication 1, **caractérisé par le fait que** l'au moins un dissipateur thermique comporte au moins une lèvre de refroidissement ou une broche de refroidissement (21).

3. Dispositif de réception selon l'une des revendications précédentes, **caractérisé par le fait qu'**au moins un élément thermoconducteur (18) est disposé entre l'élément magnétiquement conducteur (17) et la section intérieure.

4. Dispositif de réception selon la revendication 3, **caractérisé par le fait que** l'élément thermoconducteur (18) est constitué de silicium.

5. Dispositif de réception selon la revendication 3 ou 4, **caractérisé par le fait que** l'élément thermoconducteur (18) est également conçu comme un élément adhésif.

6. Dispositif de réception selon l'une des revendications précédentes, **caractérisé en ce que** le caloduc (28) est disposé dans le volume intérieur de telle sorte qu'un gradient de la température ambiante du caloduc (28) est négatif le long du parcours allant de la première région spatiale prédéterminée à la section intérieure.

7. Dispositif de réception selon l'une des revendications précédentes, **caractérisé en ce que** le dispositif de réception (1) comprend au moins une carte de circuit imprimé (10a, 10b), dans lequel au moins un élément électrique ou électronique est disposé sur la carte de circuit imprimé (10a, 10b), dans lequel la carte de circuit imprimé (10a, 10b) ou l'au moins une élément électrique ou électronique est disposé dans la première région spatiale.

8. Dispositif de réception selon l'une des revendications précédentes, **caractérisé par le fait que** la première carte de circuit imprimé (10a, 100) et/ou l'au moins un élément électrique ou électronique est relié thermiquement à l'élément de transfert de chaleur (28) par l'intermédiaire d'au moins un vias thermique.

9. Dispositif de réception selon l'une des revendications précédentes, **caractérisé par le fait que** la première carte de circuit imprimé (10a, 10b) et/ou l'au moins un élément électrique ou électronique est relié thermiquement à l'élément de transfert de chaleur (28) par l'intermédiaire d'au moins un autre élément thermoconducteur, dans lequel l'autre élément thermoconducteur n'est pas conducteur d'électricité.

10. Procédé de fabrication d'un dispositif de réception pour un système de transfert de puissance inductif, dans lequel une partie de base (2) et une partie de couvercle (3) sont fournies en tant que parties de boîtier d'un boîtier du dispositif de réception (1), dans lequel au moins une des parties de boîtier a ou forme au moins un dissipateur de chaleur sur un côté extérieur, dans lequel le dispositif de réception (1) comprend au moins un élément magnétiquement conducteur (17) et une structure d'enroulement secondaire (12), dans lequel l'élément magnétiquement conducteur (17) et la structure d'enroulement secondaire (12) sont disposés dans le volume intérieur, dans lequel l'élément magnétiquement conducteur (17) et la structure d'enroulement secondaire (12) sont disposés dans une région centrale entre deux régions de bord latéral du boîtier, dans lequel l'élément magnétiquement conducteur (17) repose sur une section intérieure de la paroi du boîtier ou est thermiquement connecté à une section intérieure de la paroi du boîtier par l'intermédiaire d'un élément thermiquement conducteur, dans lequel la section intérieure de la paroi du boîtier et le dissipateur de chaleur sont disposés dans la région centrale du boîtier, dans lequel le dissipateur de chaleur est disposé dans une section extérieure de la paroi du boîtier qui est à l'opposé de la section intérieure, dans lequel le dispositif de réception (1) comprend au moins un élément de transfert de chaleur (28), dans lequel la chaleur est transférée d'une région de bord latéral dans le volume intérieur à la section intérieure de la paroi du boîtier à travers l'au moins un élément de transfert de chaleur (28), dans lequel l'élément de transfert de chaleur (28) est conçu comme un caloduc (28), qui est disposé dans une rainure de guidage de la partie du couvercle (2).
